Europäisches Patentamt

European Patent Office

Office européen des brevets

(19)

(11) **EP 1 583 078 A1**

(12) **EUROPEAN PATENT APPLICATION**
published in accordance with Art. 158(3) EPC

(43) Date of publication:
 **05.10.2005 Bulletin 2005/40**

(51) Int Cl.⁷: **G11B 5/39**, H01L 43/08

(21) Application number: **03751362.9**

(86) International application number:
 **PCT/JP2003/012834**

(22) Date of filing: **07.10.2003**

(87) International publication number:
 **WO 2004/034382 (22.04.2004 Gazette 2004/17)**

(84) Designated Contracting States:
 **AT BE BG CH CY CZ DE DK EE ES FI FR GB GR
 HU IE IT LI LU MC NL PT RO SE SI SK TR**

(30) Priority: **09.10.2002 JP 2002296080**

(71) Applicant: **FUJITSU LIMITED
 Kanagawa 211-8588 (JP)**

(72) Inventors:
 • **KONDO, Reiko, Fujitsu Limited
  Kawasaki-shi, Kanagawa 211-8588 (JP)**

 • **SHIMIZU, Yutaka, Fujitsu Limited
  Kawasaki-shi, Kanagawa 211-8588 (JP)**
 • **TANAKA, Atsushi, Fujitsu Limited
  Kawasaki-shi, Kanagawa 211-8588 (JP)**

(74) Representative: **Stebbing, Timothy Charles
  Haseltine Lake & Co.,
  Imperial House,
  15-19 Kingsway
  London WC2B 6UD (GB)**

(54) **CPP STRUCTURE MAGNETORESISTANCE EFFECT ELEMENT AND HEADb SLIDER**

(57) A magnetoresistive film (44) extends along a datum plane (43) intersecting with a medium-opposed surface. A non-magnetic body (47) extends along the datum plane (43) at a location adjacent the magnetoresistive film (44). A so-called magnetic domain controlling films are omitted. The inventors have found that a sufficient magnetization can be established in a predetermined direction along the medium-opposed surface in the CPP structure magnetoresistive element based on the current magnetic field. As long as the quantity of the heat generated, namely of the electric power is maintained constant, the magnetic field of a sufficient intensity can be established in the free magnetic layer. The direction of the magnetization can easily be controlled in a facilitated manner.

FIG.3

EP 1 583 078 A1

## Description

### TECHNICAL FIELD

The present invention relates to a magnetoresistive (MR) element utilizing a magnetoresistive (MR) film such as a spin valve film, a tunnel- junction film, and the like. In particular, the invention relates to a current-perpendicular-to-the-plane (CPP) structure magnetoresistive element allowing a sensing current to have a component perpendicular to the surface of a substratum receiving a magnetoresistive film.

### BACKGROUND ART

A conventional CPP structure magnetoresistive element often includes a magnetoresistive film such as a spin valve film overlaid on the surface of a substratum. The spin valve film is interposed between a pair of magnetic domain controlling films along the surface of the substratum, for example. A biasing magnetic field is established between the magnetic domain controlling films in a predetermined direction. The biasing magnetic field serves to unify the magnetization of the free ferromagnetic layer within the spin valve film. A so-called Barkhausen noise can thus be suppressed. The magnetic domain controlling films are made of a hard magnetic material. Specifically, the magnetic domain controlling film forms a hard magnetic film. The intensity of the biasing magnetic field depends on the thickness of the magnetic domain controlling films and the strength of the residual magnetization.

The CPP structure MR element enables reduction in size of the magnetoresistive film as compared with a conventional current-in-the-plane, CIP, structure magnetoresistive element. The reduced size of the magnetoresistive film causes a reduced distance between the magnetic domain controlling films. This allows the free ferromagnetic layer in the magnetoresistive film to receive the biasing magnetic field of an excessive intensity. The biasing magnetic field in this case tends to hinder the rotation of magnetization in the free ferromagnetic layer.

Patent Publication 1

Japanese Patent Application Publication No. 2000-149225

### DISCLOSURE OF THE INVENTION

It is accordingly an object of the present invention to provide a current-perpendicular-to-the-plane structure magnetoresistive element capable of controlling the direction of magnetization in a free magnetic layer of a magnetoresistive film in facilitated manner in accordance with the size of the magnetoresistive film.

According to a first aspect of the present invention, there is provided a current-perpendicular-to-the-plane (CPP) structure magnetoresistive element comprising: a lower electrode defining a datum plane intersecting with a medium-opposed surface; an upper electrode opposed to the datum plane by a predetermined distance; a magnetoresistive film located in a space between the upper and lower electrodes, said magnetoresistive film extending along the datum plane in contact with the lower electrode; and a non-magnetic body extending along the datum plane at a position adjacent the magnetoresistive film.

The CPP structure magnetoresistive element allows electric current to flow between the upper and lower electrodes in the direction perpendicular to the datum plane. The inventors have confirmed that the current magnetic field is established along a horizontal cross-section perpendicular to the flow of the electric current in the direction rotating around the center of the flow. Moreover, the inventors have discovered that the intensity of the current magnetic field increases as the distance gets larger from the center of the flow. In general, when the current magnetic field is induced around a single flow of electric current, the intensity of the current magnetic field decreases depending upon an increased distance from the center of the flow. However, the inventors have found that the intensity of the current magnetic field increases as the distance gets larger from the center of the flow if the electric current having a uniform distribution over the horizontal cross-section flows in the vertical direction. The inventors have found that the magnetization of a sufficient intensity can be established in a predetermined direction along the medium-opposed surface in the CPP structure magnetoresistive element based on the current magnetic field. The inventors have found that the current magnetic field can be utilized to control the direction of the magnetization in the free magnetic layer.

In general, the value of electric current is set based on the heat generation of the magnetoresistive film in the CPP structure magnetoresistive element. Accordingly, as long as the quantity of the heat generated, namely of the electric power is maintained constant, the current magnetic field serves to establish the magnetic field of a sufficient intensity within the free magnetic layer. The magnetization can easily be controlled in the free magnetic layer irrespective of reduction in the size of the magnetoresistive film.

The CPP structure magnetoresistive element may further comprise: upper and lower shielding layers sandwiching the upper and lower electrodes, the magnetoresistive film and the non-magnetic body along the medium-opposed surface; and a soft magnetic body extending along the medium-opposed surface from the upper shielding layer to the lower shielding layer in parallel with the magnetoresistive film.

The soft magnetic body serves as a shielding layer, so that the magnetic field acts on the magnetoresistive film over a reduced extent. In particular, a higher resolution can be achieved for magnetic information data in the lateral direction of recording tracks. The CPP structure magnetoresistive element thus contributes to a further improvement of recording density. In this case, the soft magnetic body may be connected to either one of the upper and lower shielding layers. The upper shielding layer may serve as the upper electrode in the CPP structure magnetoresistive element. The lower shielding layer may serve as the lower electrode in the CPP structure magnetoresistive element.

According to a second aspect of the present invention, there is provided a magnetoresistive element comprising: a magnetoresistive film extending along a datum plane intersecting with a medium-opposed surface; upper and lower shielding layers sandwiching the magnetoresistive film along the medium-opposed surface; and a soft magnetic body extending along the medium-opposed surface from the upper shielding layer to the lower shielding layer in parallel with the magnetoresistive film.

The soft magnetic body serves as a shielding layer in the magnetoresistive film, so that the magnetic field acts on the magnetoresistive film over a reduced extent. In particular, a higher resolution can be achieved for magnetic information data in the lateral direction of recording tracks. The CPP structure magnetoresistive element thus contributes to a further improvement of recording density. In this case, the soft magnetic body may be connected to either one of the upper and lower shielding layers. The upper shielding layer may serve as the upper electrode in the magnetoresistive element. The lower shielding layer may serve as the lower electrode in the magnetoresistive element.

The aforementioned CPP structure magnetoresistive element as well as the aforementioned magnetoresistive element may be utilized in a head slider, for example. The head slider is usually employed in a magnetic recording medium drive such as a hard disk drive, for example.

BRIEF DESCRIPTION OF THE DRAWINGS

Fig. 1 is a plan view schematically illustrating the structure of a hard disk drive (HDD) as an example of a magnetic recording medium drive.

Fig. 2 is an enlarged perspective view schematically illustrating the structure of a flying head slider according to a specific example.

Fig. 3 is a front view schematically illustrating a read/write electromagnetic transducer observed at a bottom surface.

Fig. 4 is an enlarged front view schematically illustrating the structure of a current-perpendicular-to-the-plane (CPP) structure MR read element according to a first embodiment of the present invention.

Fig. 5 is a schematic view illustrating the magnetic field generated within a free ferromagnetic layer based on electric current.

Fig. 6 is a schematic view illustrating the direction of the magnetization controlled within the free ferromagnetic layer based on electric current.

Figs. 7A and 7B are schematic views illustrating the conditions of the magnetization changing in the free ferromagnetic layer in response to the inversion of the applied magnetic field when the magnetization is controlled in the free ferromagnetic layer based on the electric current.

Fig. 8 is a schematic view illustrating the direction of the magnetization in a free ferromagnetic layer based on electric current and magnetic domain controlling films.

Figs. 9A and 9B are schematic views illustrating the conditions of the magnetization changing in the free ferromagnetic layer in response to the inversion of the applied magnetic field when the magnetization is controlled in the free ferromagnetic layer based on the electric current and the magnetic domain controlling films.

Fig. 10 is a graph illustrating the distribution of intensity for the magnetic field established within the free ferromagnetic layer of a magnetoresistive film having sides of $0.32\mu m$ long each.

Fig. 11 is a graph illustrating the distribution of intensity for the magnetic field established within the free ferromagnetic layer of a magnetoresistive film having sides of $0.16\mu m$ long each.

Fig. 12 is a graph illustrating the distribution of intensity for the magnetic field established within the free ferromagnetic layer of a magnetoresistive film having sides of $0.08\mu m$ long each.

Fig. 13 is an enlarged partial sectional view of a substrate for schematically illustrating a resist film formed on the magnetoresistive film in the production process of the magnetoresistive film.

Fig. 14 is an enlarged partial sectional view of the substrate for schematically illustrating a process of shaping the magnetoresistive film and the upper electrode.

Fig. 15 is an enlarged partial sectional view of the substrate for schematically illustrating a process of forming a non-magnetic layer.

Fig. 16 an enlarged partial sectional view of the substrate for schematically illustrating a process of exposing the upper surface of the upper electrode.

Fig. 17 is a front view, corresponding to Fig. 3, schematically illustrating the structure of a CPP structure MR read element according to a second embodiment of the present invention.

Fig. 18 is an enlarged partial sectional view of a substrate for schematically illustrating a process of forming a non-magnetic film and a soft magnetic material film.

Fig. 19 is an enlarged partial sectional view of the substrate for schematically illustrating a process of shaping soft magnetic pieces out of the soft magnetic material film.

Fig. 20 is an enlarged partial sectional view of the substrate for schematically illustrating a process of forming the non-magnetic layer.

Fig. 21 is an enlarged partial sectional view of a substrate for schematically illustrating a process of exposing the upper electrode and the soft magnetic pieces.

Fig. 22 is an enlarged front view, corresponding to Fig. 4, schematically illustrating the structure of a spin valve film according to another example.

Fig. 23 is an enlarged front view, corresponding to Fig. 4, schematically illustrating the structure of a tunnel junction film according to an example.

BEST MODE FOR CARRYING OUT THE INVENTION

Description will be made below on an embodiment of the present invention referring to the attached drawings.

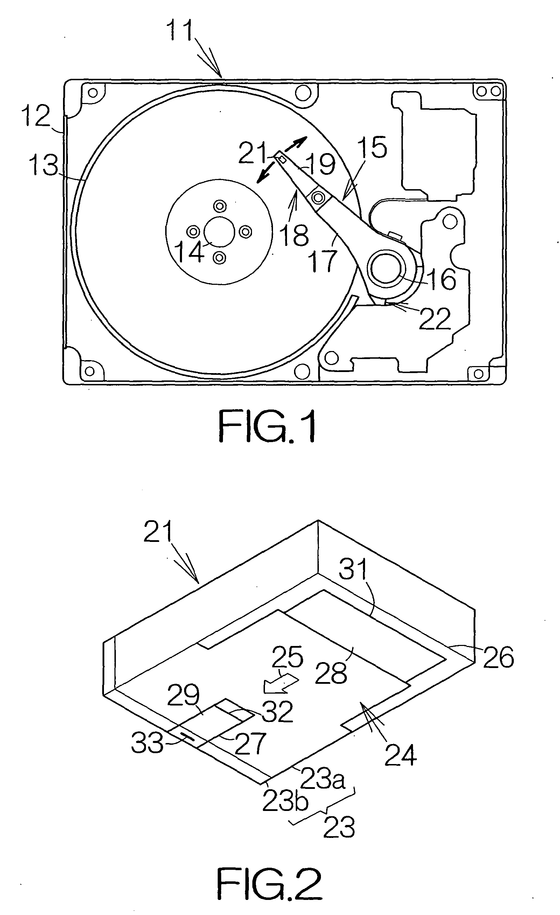

Fig. 1 schematically illustrates the inner structure of a hard disk drive (HDD) 11 as an example of a magnetic recording device or storage system. The HDD 11 includes a box-shaped main enclosure 12 defining an inner space of a flat parallelepiped, for example. At least one magnetic recording disk 13 is incorporated in the inner space within the main enclosure 12. The magnetic recording disk 13 is mounted on the driving shaft of a spindle motor 14. The spindle motor 14 is allowed to drive the magnetic recording disk 13 for rotation at a higher revolution speed such as 7,200rpm or 10,000rpm, for example. A cover, not shown, is coupled to the main enclosure 12 so as to define the closed inner space between the main enclosure 12 and itself.

A head actuator 15 is also incorporated within the inner space of the main enclosure 12. The head actuator 15 is coupled to a vertical support shaft 16 for relative rotation. The head actuator 15 includes rigid actuator arms 17 extending from the vertical support shaft 16 in the horizontal direction. A head suspension assembly 18 is attached to the tip or front end of the individual actuator arm 17 so as to extend forward from the actuator arm 17. The actuator arms 17 are related to the front and back surfaces of the magnetic recording disk 13.

The head suspension assembly 18 includes a load beam 19. The load beam 19 is connected to the front end of the actuator arm 17 through a so-called elastic deformable section. The elastic deformable section serves to generate a predetermined urging force directed toward the surface of the magnetic recording disk 13. A flying head slider 21 is supported at the front end of the load beam 19. The flying head slider 21 is received on a gimbal spring, not shown, fixed to the load beam 19 for relative change of attitude.

When the magnetic recording disk 13 rotates, the flying head slider 21 is allowed to receive airflow generated along the surface of the rotating magnetic recording disk 13. The airflow serves to generate a positive pressure or lift as well as a negative pressure on the flying head slider 21. The flying head slider 21 is thus allowed to keep flying above the surface of the magnetic recording disk 13 during the rotation of the magnetic recording disk 13 at a higher stability established by the balance between the urging force of the load beam 19 and a combination of the lift and the negative pressure.

A power source 22 such as a voice coil motor (VCM) is connected to the actuator arm 17, for example. The power source 22 serves to realize the swinging movement of the actuator arm 17 around the support shaft 16. The rotation of the actuator arm 17 enables the movement of the head suspension assembly 18 in the radial direction of the magnetic recording disk 13. When the actuator arm 17 is driven to swing about the support shaft 16 during the flight of the flying head slider 21, the flying head slider 21 is allowed to cross the recording tracks defined on the magnetic recording disk 13 in the radial direction of the magnetic recording disk 13. This radial movement serves to position the flying head slider 21 right above a target recording track on the magnetic recording disk 13.

Fig. 2 illustrates a specific example of the flying head slider 21. The flying head slider 21 of this type includes a slider body 23 in the form of a flat parallelepiped, for example. The slider body 23 is designed to oppose the medium-opposed surface, namely a bottom surface 24, to the magnetic recording disk 13. A flat base surface or datum plane is defined on the bottom surface 24. When the magnetic recording disk 13 rotates, airflow 25 flows along the bottom surface 24 from the leading or inflow end to the trailing or outflow end. The slider body 23 may include a substrate 23a made of $Al_2O_3$-TiC and an $Al_2O_3$ (alumina) film 23b overlaid on the trailing end surface of the substrate 23a.

A front rail 26 and a rear rail 27 are formed on the bottom surface 24 of the slider body 23. The front rail 26 is designed to extend along the inflow or leading end of the slider body 23. The rear rail 27 is located near the outflow or trailing end of the slider body 23. Air bearing surfaces (ABSs) 28, 29 are respectively defined on the top surfaces of the front and rear rails 26, 27. The inflow ends of the air bearing surfaces 28, 29 are connected to the top surfaces of the front and rear rails 26, 27 through steps 31, 32, respectively.

The bottom surface 24 of the flying head slider 21 is designed to receive airflow 25 generated along the rotating magnetic recording disk 13. The steps 31, 32 serve to generate a relatively larger positive pressure or lift at the air bearing surfaces 28, 29. Moreover, a larger negative pressure is induced behind the front rail 26. The negative pressure is balanced with the lift so as to stably establish a flying attitude of the flying head slider 21.

A read/write electromagnetic transducer 33 is mounted on the slider body 23. The read/write electromagnetic transducer 33 is embedded within the alumina film 23b of the slider body 23. A read gap and a write gap of the read/write electromagnetic transducer 33 are exposed at the air bearing surface 29 of the rear rail 27. It should be noted that a diamond-like-carbon (DLC) protection film may extend over the surface of the air bearing surface 29 so as to cover over the front end of the read/write electromagnetic transducer 33. The read/write electromagnetic transducer 33 will be described later in detail. The flying head slider 21 may take any shape or form other than the aforementioned one.

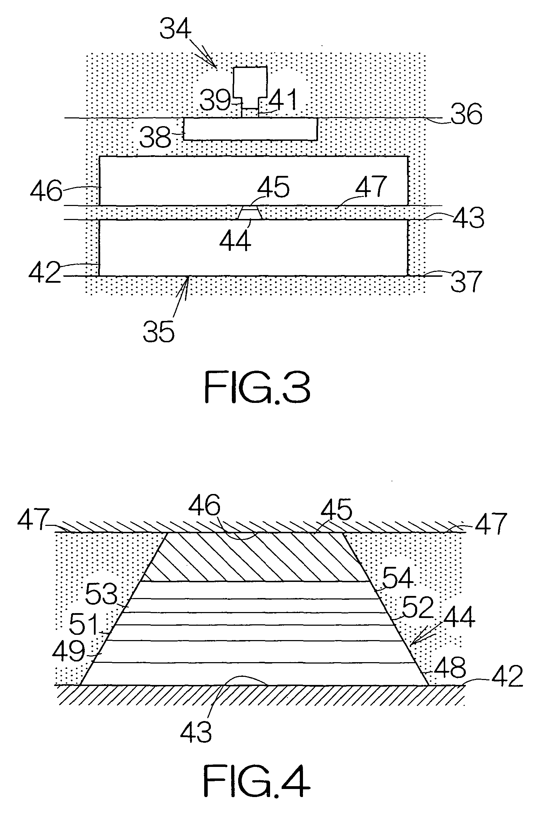

Fig. 3 illustrates an enlarged detailed view of the read/write electromagnetic transducer 33 exposed at the air bearing surface 29. The read/write electromagnetic transducer 33 comprises an inductive write element or a thin film magnetic head 34 and a current-perpendicular-to-the-plane (CPP) structure electromagnetic transducer element or CPP structure magnetoresistive (MR) read element 35 according to a first embodiment of the present invention. The thin film magnetic head 34 is designed to write a magnetic bit data onto the magnetic recording disk 13 by utilizing a magnetic field induced in a conductive swirly coil pattern, not shown, for example. The CPP structure MR read element 35 is designed to detect a magnetic bit data by utilizing variation of the electric resistance in response to the inversion of the magnetic polarity in a magnetic field acting from the magnetic recording disk 13. The thin film magnetic head 34 and the CPP structure MR read element 35 are interposed between an $Al_2O_3$ (alumina) layer 36 as an upper half layer of the alumina film 23b or overcoat film and an $Al_2O_3$ (alumina) layer 37 as a lower half layer of the alumina film 23b or undercoat film.

The thin film magnetic head 34 includes an upper magnetic pole layer 38 exposing the front end at the air bearing surface 29, and a lower magnetic pole layer 39 likewise exposing the front end at the air bearing surface 29. The upper and lower magnetic pole layers 38, 39 may be made of FeN, NiFe, or the like, for example. The combination of the upper and lower magnetic pole layers 38, 39 establishes the magnetic core of the thin film magnetic head 34.

A non-magnetic gap layer 41 is interposed between the upper and lower magnetic pole layers 38, 39. The non-magnetic gap layer 41 may be made of $Al_2O_3$ (alumina), for example. When a magnetic field is induced at the conductive swirly coil pattern, a magnetic flux is exchanged between the upper and lower magnetic pole layers 38, 39. The non-magnetic gap layer 41 allows the exchanged magnetic flux to leak out of the air bearing surface 29. The thus leaked magnetic flux forms a magnetic field for recordation, namely, a write gap magnetic field.

The CPP structure MR read element 35 includes a lower electrode 42 spreading over the upper surface of the alumina layer 37 as a basement insulation layer. The lower electrode 42 may have not only a property of electric conductors but also a soft magnetic property. If the lower electrode 42 is made of a soft magnetic electric conductor, such as NiFe, for example, the lower electrode 42 is also allowed to serve as a lower shielding layer for the CPP structure MR read element 35.

A flattened surface or datum plane 43 is defined on the upper surface of the lower electrode 42. The flattened surface 43 is designed to intersect with the bottom surface 24 at right angles. A magnetoresistive (MR) film 44 is overlaid on the flattened surface 43. The magnetoresistive film 44 is patterned into a predetermined contour. The magnetoresistive film 44 extends rearward from the tip or front end exposed at the air bearing surface 29 along the flattened surface 43. Contact and electric connection is thus established between the magnetoresistive film 44 and the lower electrode 42. The structure of the magnetoresistive film 44 will be described later in detail.

An upper electrode 45 is located on the magnetoresistive film 44. The magnetoresistive film 44 is thus interposed between the upper and lower electrodes 45, 42. An upper shielding layer 46 is located on the upper electrode 45. The upper shielding layer 46 may have not only a soft magnetic property but also a property of electric conductors. Likewise, the upper electrode 45 may have not only a property of electric conductors but also a soft magnetic property. If the upper electrode 45 is made of a soft magnetic electric conductor, such as NiFe, for example, the upper electrode 45 is also allowed to serve as an upper shielding layer for the CPP structure MR read element 35. The distance between the aforementioned lower electrode 42 and the upper electrode 45 determines a linear resolution of recordation along a recording track on the magnetic recording disk 13.

A non-magnetic layer 47 extends on the flattened surface 43 at a position adjacent the magnetoresistive film 44. The non-magnetic layer 47 is interposed between the lower electrode 42 and the upper shielding layer 46. The non-magnetic layer 47 may be made of an insulating material such as $Al_2O_3$, $SiO_2$, or the like. Since the non-magnetic layer 47 has an insulating property, short circuit is prevented between the upper shielding layer 46 and the lower electrode 42 even if the upper shielding layer 46 has a property of electric conductivity.

Fig. 4 illustrates an enlarged view of the CPP structure MR read element 35. The magnetoresistive film 44 is a so-called spin valve film. Specifically, the magnetoresistive film 44 includes a basement layer 48, a pinning layer 49, a pinned ferromagnetic layer 51, a non-magnetic intermediate layer 52 made of an electrically conductive material, a free ferromagnetic layer 53 and a protection cap layer 54 overlaid on the flattened surface 43 in this sequence. The pinned and free ferromagnetic layers 51, 53 may be made of a soft magnetic material such as NiFe, for example. The pinning layer 49 may be made of an antiferromagnetic material such as IrMn or the like. The magnetization of the pinned ferromagnetic layer 51 is fixed in a specific lateral direction under the influence of the pinning layer 49. The non-magnetic intermediate layer 52 may be made of Cu or the like.

When the CPP structure MR read element 35 is opposed to the surface of the magnetic recording disk 13 for reading magnetic information data, the magnetoresistive film 44 allows the magnetization of the free ferromagnetic layer 53 to rotate in response to the inversion of the magnetic polarity applied from the magnetic recording disk 13. The rotation of the magnetization in the free ferromagnetic layer 53 induces variation in the electric resistance of the magnetoresistive film 44. When a sensing current is supplied to the magnetoresistive film 44 through the upper electrode 45 and the lower electrode 42, a variation in the voltage appears, in response to the variation in the magnetoresistance, in the sensing current output from the upper electrode layer 45 and the lower electrode 42. The variation in the level can be utilized to detect a magnetic bit data recorded on the magnetic recording disk 13.

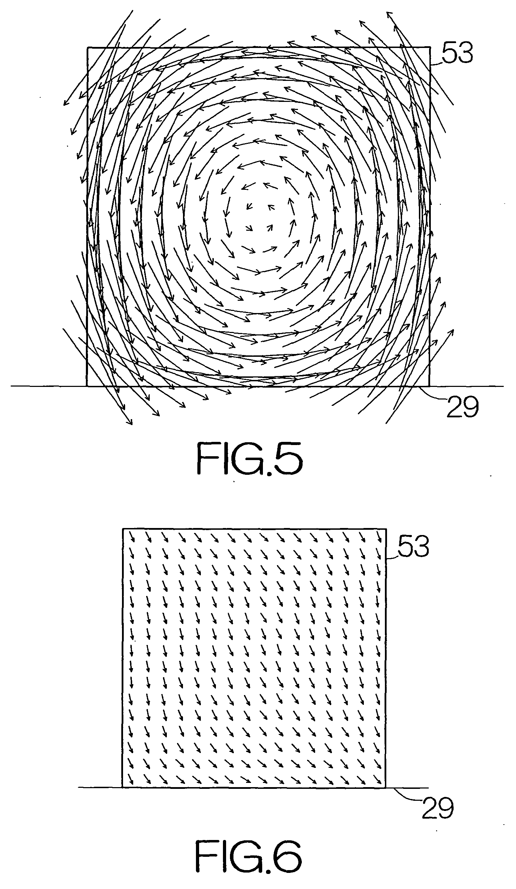

Here, the inventors have observed the current magnetic field within the free ferromagnetic layer 53 in response to supply of electric current. The inventors executed software programs for analyzing the magnetic field on a computer. The electric current was set to flow through the magnetoresistive film 44 in the vertical direction perpendicular to the flattened surface 43. As shown in Fig. 5, the current magnetic field was observed along a horizontal plane perpendicular to the flow of the electric current in the direction rotating around the center of the flow. Moreover, the inventors have discovered that the intensity of the current magnetic field increases in the free ferromagnetic layer 53 as the distance gets larger from the center of the flow. In general, when the current magnetic field is induced around a single flow of electric current, the intensity of the magnetic field decreases depending upon an increased distance from the center of the flow. However, the inventors have found that the intensity of the current magnetic field increases as the distance gets larger from the center of the flow if the electric current having a uniform distribution over the horizontal cross-section flows in the vertical direction. In particular, the direction of the magnetization was set along the air bearing surface 29 in the current magnetic field, as is apparent from Fig. 5. The inventors have found that the magnetization of a sufficient intensity is established in a predetermined direction along the air bearing surface 29 in the CPP structure MR read element 35.

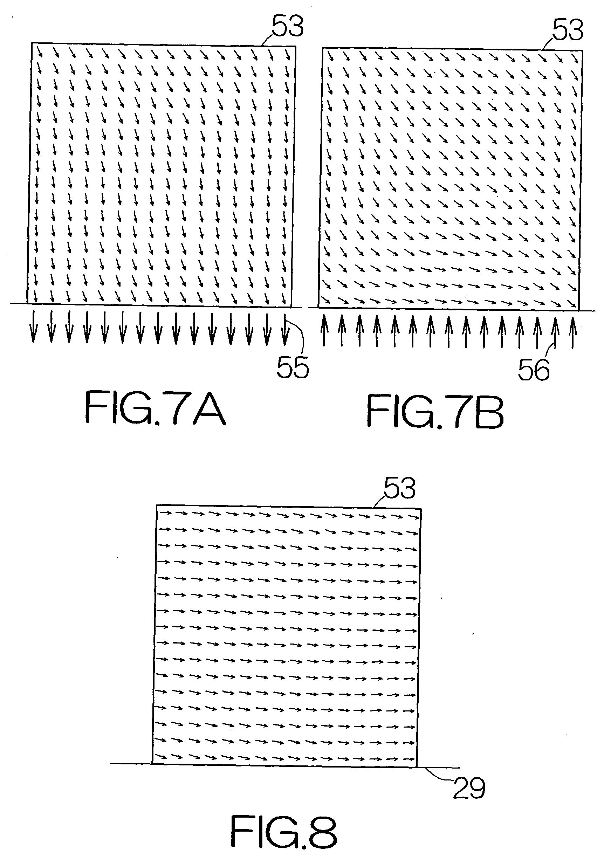

The inventors have further observed the magnetic field generated in the free ferromagnetic layer 53. The aforementioned software programs were again employed for observation. Here, the magnetic field of the pinned ferromagnetic layer 51, the magnetostatic influence and the exchange interaction were taken into consideration in addition to the influence of the current magnetic field. The contour of the magnetoresistive film 44 was set at a square having sides of 0.16μm long each. As is apparent from Fig. 6, the inventors have confirmed that generation of magnetic or domain walls is avoided in the free ferromagnetic layer 53. Moreover, the inventors have demonstrated that a sufficient rotation of the magnetization is established between the case where the magnetic field 55 of recordation flows into the magnetic recording disk 13 and the case where the magnetic field 56 of recordation flows out of the magnetic recording disk 13, as is apparent from Fig. 7. Establishment of domain walls was avoided in both the cases. It should be noted that the individual arrows specify the direction of the magnetization in Figs. 6 and 7.

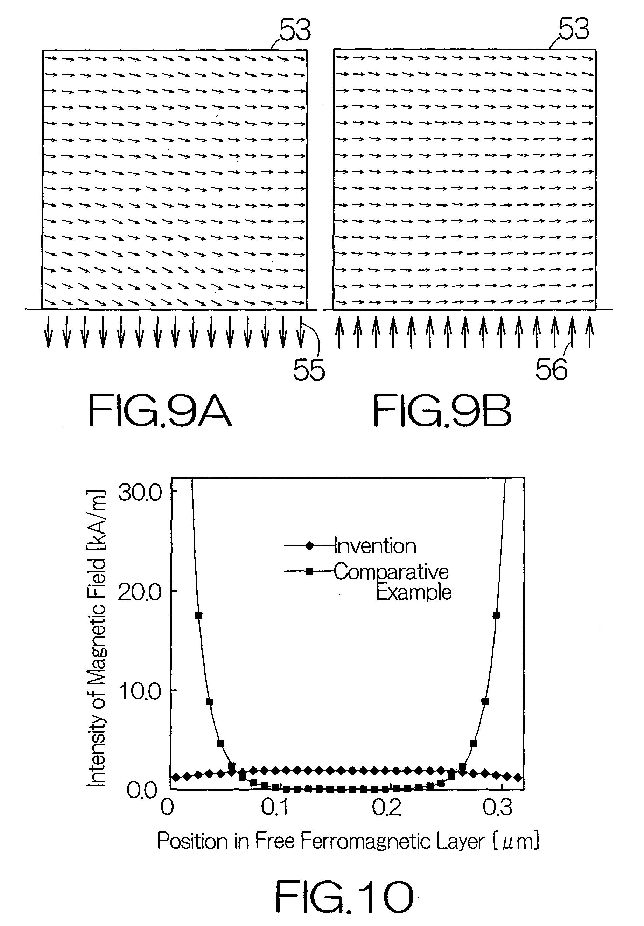

Simultaneously, the inventors have observed the magnetic field generated in the free ferromagnetic layer in a CPP structure MR read element according to a comparative example. The aforementioned magnetoresistive film 44 was structured in the CPP structure MR read element of the comparative example. In this case, the magnetoresistive film 44 was located between a pair of magnetic domain controlling film along the air bearing surface. A biasing magnetic field was established in a predetermined direction between the magnetic domain controlling films across the free ferromagnetic layer. As is apparent from Fig. 8, the inventor has confirmed the influence of the biasing magnetic field in the free ferromagnetic layer. As shown in Fig. 9, the inventors have demonstrated that rotation of the magnetization is established between the case where the magnetic field 55 of recordation flows into the magnetic recording disk 13 and the case where the magnetic field 56 of recordation flows out of the magnetic recording disk 13. This fact demonstrates the realization of the aforementioned CPP structure MR read element 35.

The inventors have thereafter observed the distribution of intensity for the current magnetic field generated in the magnetoresistive film 44 and the distribution of intensity for the biasing magnetic field in the magnetoresistive film 44 in the CPP structure MR read element of the comparative example. The aforementioned software programs were again employed for observation. Here, the magnitude of the electric current was set in accordance with the following expression:

[Equation 1]

$$I^2 R = P \ (= const.) \qquad (1)$$

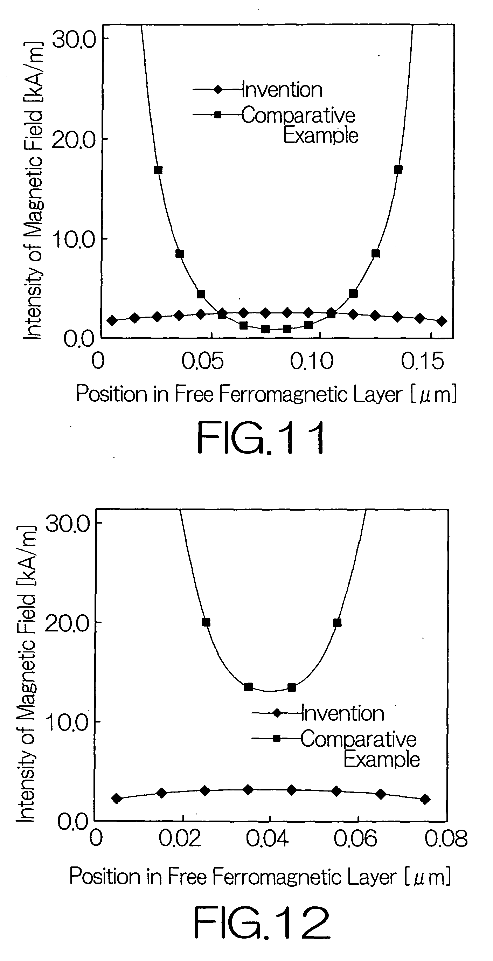

Here, the value of the electric current was set based on the heat generation in the magnetoresistive film 44, namely P=550μW. The position of the magnetic field was determined in accordance with the distance from the end of the free ferromagnetic layer 53 along the air bearing surface 29. As shown in Fig. 10, if the magnetoresistive film 44 is shaped into a square having sides of 0.32μm long each, the magnetic field exhibits a nearly constant intensity along the air bearing surface 29 in the CPP structure MR read element 35. On the other hand, the CPP structure MR read element of the comparative example exhibits a magnetic field of the intensity lower than that of the current magnetic field in a range approximately between 0.05μm and 0.25μm. As is apparent from Fig. 11, if the magnetoresistive film 44 is shaped into a square having sides of 0.16μm long each, the magnetic field likewise exhibits a nearly constant intensity along the air bearing surface 29 in the CPP structure MR read element 35. As is apparent from Fig. 12, if the magnetoresistive film 44 is shaped into a square having sides of 0.08μm long each, the magnetic field likewise exhibits a nearly constant intensity along the air bearing surface 29 in the CPP structure MR read element 35. On the other hand, the CPP structure MR read element of the comparative example exhibits a magnetic field of a remarkably stronger intensity all along the air bearing surface 29. The rotation of the magnetization is hindered in the free ferromagnetic layer in the CPP structure MR read element of the comparative example. The magnetization of the free ferromagnetic layer 53 can be controlled in the magnetoresistive film 44 of a square having sides smaller than 0.1μm long each based on the current magnetic field in a facilitated manner as compared with the conventional magnetic domain controlling films. As long as the conditions follow the aforementioned equation (1), the magnetization can easily be controlled irrespective of reduction in the size of the magnetoresistive film 44.

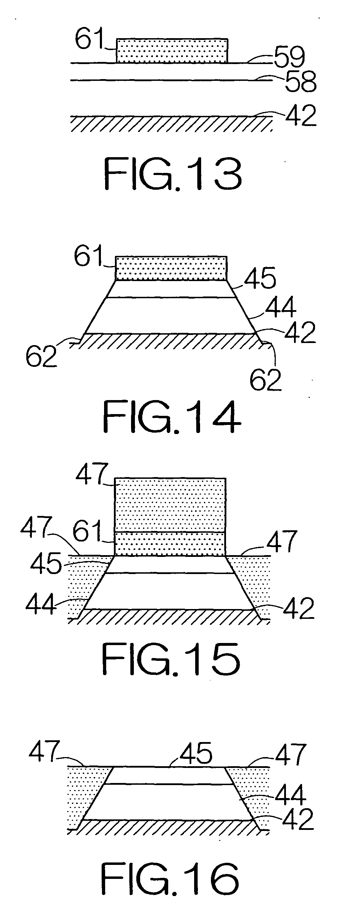

As shown in Fig. 13, first and second material films 58, 59 are sequentially formed on the lower electrode 42 over the surface of a predetermined substrate in the production process of the CPP structure MR read element 35. The first material film 58 has the layered structure identical to that of the aforementioned magnetoresistive film 44. The second material film 59 may be made of an electrically conductive material such as NiFe. A resist film 61 is formed on the surface of the second material film 59 in a predetermined pattern.

Etching process is effected based on the resist film 61. Ion milling may be employed in the etching process, for example. As shown in Fig. 14, the first and second material films 58, 59 are removed around the resist film 61. The magnetoresistive film 44 is in this manner shaped out of the first material film 58. The upper electrode 45 is simultaneously shaped out of the secondmaterial film 59. Here, the surface of the lower electrode 42 may partially be scraped around the magnetoresistive film 44. As is apparent from Fig. 14, the steps 62 are thus formed at the lower electrode 42. The steps 62 is continuous to the contour of the magnetoresistive film 44.

The non-magnetic film 47 having an insulating property is formed on the lower electrode 42. Sputtering may be employed to form the lower electrode 42. As shown in Fig. 15, the magnetoresistive film 44 and the upper electrode 45 are embedded within the non-magnetic film 47. The non-magnetic film 47 uniformly contacts the exposed surrounding surfaces of the magnetoresistive film 44 and the upper electrode 45.

As shown in Fig. 16, the resist film 61 is removed after the formation of the non-magnetic layer 47. The removal of the resist film 61 causes lift-off of the non-magnetic layer 47 on the resist film 61. The upper electrode 45 thus gets exposed at a gap of the non-magnetic layer 47. The upper shielding layer 46 is thereafter formed on the non-magnetic layer 47 and the upper electrode 45.

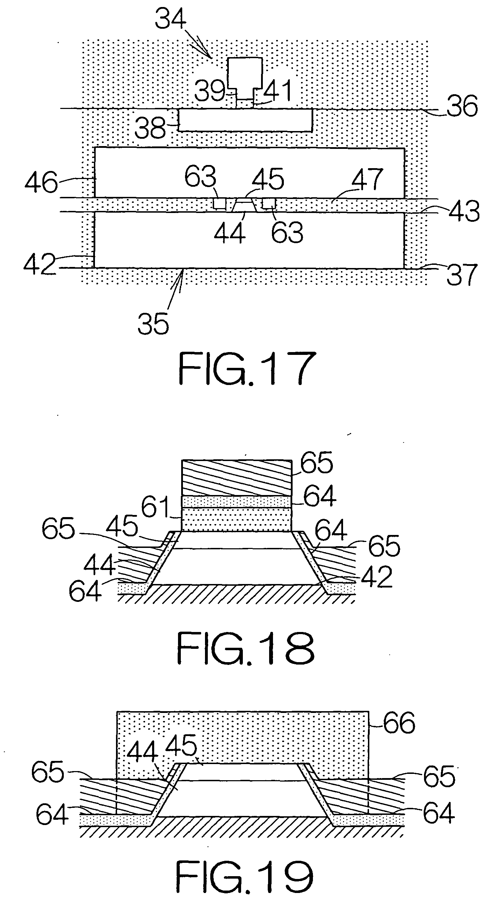

Fig. 17 schematically illustrates a CPP structure MR read element 35a according to a second embodiment of the present invention. The CPP structure MR read element 35a includes a soft magnetic pieces 63 extending toward the lower electrode 42 from the upper shielding layer 46 along the air bearing surface 29. The soft magnetic pieces 63 are designed to extend in parallel with the magnetoresistive film 44 along the air bearing surface 29. The magnetoresistive film 44 is thus located between the soft magnetic pieces 63. The individual soft magnetic pieces 63 are electrically isolated from the magnetoresistive film 44 with the insulating non-magnetic layer 47. The soft magnetic pieces 63 may contact with the upper shielding layer 46 as shown in Fig. 17 or may alternatively contact with the lower electrode 42. The soft magnetic piece 63 should be prevented from a simultaneous contact with the upper shielding layer 46 and the lower electrode 42. Like reference numerals are attached to structure or components identical to those of the aforementioned first embodiment.

The CPP structure MR read element 35a enables control on the direction of the magnetization in the free ferromagnetic layer 53 based on the current magnetic field in the same manner as described above. Moreover, since the soft magnetic pieces 63 serve as shielding layers, the magnetic field from the magnetic recording disk 13 acts on the magnetoresistive film 44 over a reduced extent. In particular, a higher resolution can be achieved for magnetic information data in the lateral direction of recording tracks. The CPP structure MR read element 35a thus contributes to a further improvement of recording density.

The first and second material films 58, 59 may be employed to form the CPP structure MR read element 35a in the same manner as described above. The magnetoresistive film 44 and the upper electrode 45 are formed out of the first and second material films 58, 59, as shown in Figs. 13 and 14. A basement non-magnetic film 64 and a soft magnetic material film 65 are then sequentially formed over the lower electrode 42. Sputtering may be employed to form the basement non-magnetic film 64 and the soft magnetic material film 65, for example. As shown in Fig. 18, the magnetoresistive film 44 and the upper electrode 45 are thus covered with the basement non-magnetic film 64 and the soft magnetic material film 65. The basement non-magnetic film 64 uniformly contacts with the exposed surrounding surfaces of the magnetoresistive film 44 and the upper electrode 45.

The resist film 61 is removed after the formation of the basement non-magnetic film 64 and the soft magnetic material film 65. The removal of the resist film 61 causes lift-off of the basement non-magnetic film 64 and the soft magnetic material film 65 on the resist film 61. The upper surface of the upper electrode 45 thus gets exposed. A resist film 66 is thereafter formed on the soft magnetic material film 65 and the upper electrode 45 in a predetermined pattern. Etching process is then effected based on the resist film 66. Ion milling may be employed in the etching process, for example. The soft magnetic material film 65 is removed around the resist film 66. The soft magnetic pieces 63 are in this manner formed out of the soft magnetic material film 65. Here, the upper surface of the basement non-magnetic film 64 may partially be scraped off around the soft magnetic pieces 63.

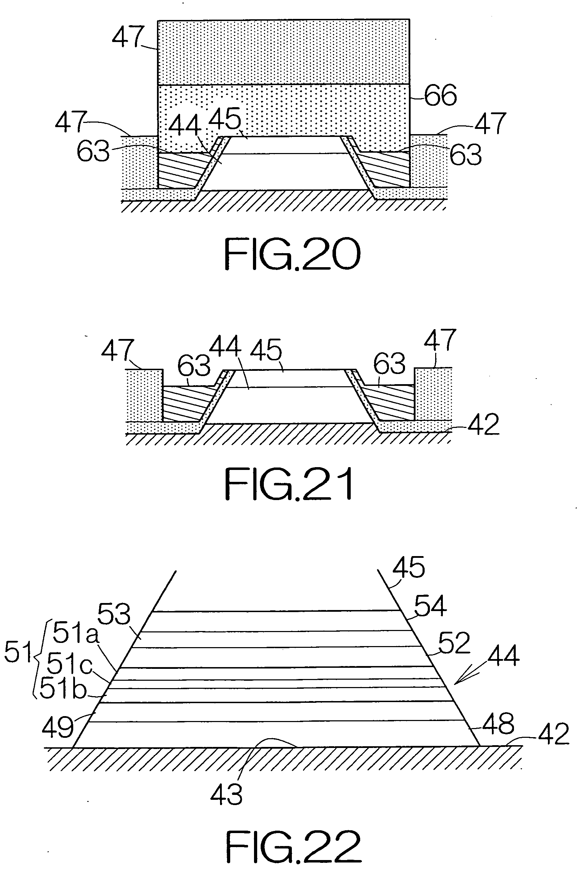

The insulating non-magnetic layer 47 is then formed on the lower electrode 42. Sputtering may be employed to form the non-magnetic layer 47. As shown in Fig. 20, the non-magnetic layer 47 uniformly contacts the soft magnetic pieces 63. The magnetoresistive film 44 and the upper electrode 45 are embedded within the non-magnetic layer 47. As shown in Fig. 21, the resist film 66 is removed after the formation of the non-magnetic layer 47. The removal of the resist film 66 causes lift-off of the non-magnetic layer 47 on the resist film 66. The upper electrode 45 thus gets exposed at a gap of the non-magnetic layer 47. The upper shielding layer 46 is thereafter formed on the non-magnetic layer 47, the upper electrode 45 and the soft magnetic pieces 63.

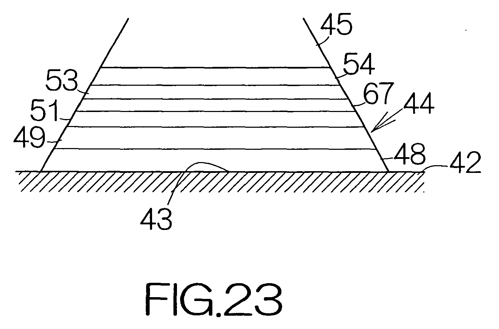

As shown in Fig. 22, a layered ferrimagnetic film 51 may be employed as the pinned ferromagnetic layer 51 in the aforementioned magnetoresistive film 44. In this case, the pinned ferromagnetic layer 51 may include a pair of CoFeB layer 51a, 51b and a Ru layer 51c interposed between the CoFeB layers 51a, 51b, for example. As conventionally known, a PdPtMn layer may be employed as the pinning layer 49. Otherwise, a tunnel-junction magnetoresistive (TMR) film may be employed as the magnetoresistive film 44, as shown in Fig. 23. In this case, the aforementioned non-magnetic intermediate layer having a property of electrical conductivity may be replaced with a thin film insulating layer 67 between the pinned and free ferromagnetic layers 51, 53.

**Claims**

1. A current-perpendicular-to-the-plane structure magnetoresistive element comprising:

   a lower electrode defining a datum plane intersecting with a medium-opposed surface;
   an upper electrode opposed to the datum plane by a predetermined distance;
   a magnetoresistive film located in a space between the upper and lower electrodes, said magnetoresistive film extending along the datum plane in contact with the lower electrode; and
   a non-magnetic body extending along the datum plane at a position adjacent the magnetoresistive film.

2. The current-perpendicular-to-the-plane structure magnetoresistive element according to claim 1, further comprising:

   upper and lower shielding layers sandwiching the upper and lower electrodes, the magnetoresistive film and the non-magnetic body along the medium-opposed surface; and
   a soft magnetic body extending along the medium-opposed surface from the upper shielding layer to the lower shielding layer in parallel with the magnetoresistive film.

3. The current-perpendicular-to-the-plane structure magnetoresistive element according to claim 2, wherein said soft magnetic body is connected to either one of the upper and lower shielding layers.

4. The current-perpendicular-to-the-plane structure magnetoresistive element according to claim 2, wherein said upper shielding layer serves as the upper electrode.

5. The current-perpendicular-to-the-plane structure magnetoresistive element according to claim 2, wherein said lower shielding layer serves as the lower electrode.

6. A head slider comprising:

   a slider body opposing a medium-opposed surface to a recording medium;
   a lower electrode defining a datum plane intersecting with the medium-opposed surface;
   an upper electrode opposed to the datum plane by a predetermined distance;
   a magnetoresistive film located in a space between the upper and lower electrodes, said magnetoresistive film extending along the datum plane in contact with the lower electrode; and
   a non-magnetic body extending along the datum plane at a position adjacent the magnetoresistive film.

7. The head slider according to claim 6, further comprising:

   upper and lower shielding layers sandwiching the upper and lower electrodes, the magnetoresistive film and the non-magnetic body along the medium-opposed surface; and
a soft magnetic body extending along the medium-opposed surface from the upper shielding layer to the lower shielding layer in parallel with the magnetoresistive film.

8. The head slider according to claim 7 , wherein said soft magnetic body is connected to either one of the upper and lower shielding layers.

9. A magnetoresistive element comprising:

a magnetoresistive film extending along a datum plane intersecting with a medium-opposed surface;
upper and lower shielding layers sandwiching the magnetoresistive film along the medium-opposed surface; and
a soft magnetic body extending along the medium-opposed surface from the upper shielding layer to the lower shielding layer in parallel with the magnetoresistive film.

10. The magnetoresistive element according to claim 9, further comprising:

an upper electrode located in a space between the upper shielding layer and the magnetoresistive film in contact with the magnetoresistive film; and
a lower electrode located in a space between the lower shielding layer and the magnetoresistive film in contact with the magnetoresistive film.

11. The magnetoresistive element according to claim 10, wherein said soft magnetic body is connected to either one of the upper and lower shielding layers.

12. A head slider comprising:

a slider body opposing a medium-opposed surface to a recording medium;
a magnetoresistive film extending along a datum plane intersecting with the medium-opposed surface;
upper and lower shielding layers sandwiching the magnetoresistive film along the medium-opposed surface; and
a soft magnetic body extending along the medium-opposed surface from the upper shielding layer to the lower shielding layer in parallel with the magnetoresistive film.

13. The head slider according to claim 12, further comprising:

an upper electrode located in a space between the upper shielding layer and the magnetoresistive film in contact with the magnetoresistive film; and
a lower electrode located in a space between the lower shielding layer and the magnetoresistive film in contact with the magnetoresistive film.

14. The head slider according to claim 13, wherein said soft magnetic body is connected to either one of the upper and lower shielding layers.

FIG.1

FIG.2

## FIG.3

## FIG.4

FIG.5

FIG.6

53

FIG.7A

55

53

56

FIG.7B

53

29

FIG.8

FIG.9A

FIG.9B

FIG.10

FIG.11

FIG.12

FIG.13

FIG.14

FIG.15

FIG.16

FIG.17

FIG.18

FIG.19

FIG.20

FIG.21

FIG.22

FIG.23

## INTERNATIONAL SEARCH REPORT

| | International application No. |
|---|---|
| | PCT/JP03/12834 |

| A. CLASSIFICATION OF SUBJECT MATTER |
|---|
| Int.Cl⁷ G11B5/39, H01L43/08 |

According to International Patent Classification (IPC) or to both national classification and IPC

| B. FIELDS SEARCHED |
|---|
| Minimum documentation searched (classification system followed by classification symbols) |
| Int.Cl⁷ G11B5/39, H01L43/08 |

Documentation searched other than minimum documentation to the extent that such documents are included in the fields searched

| | | | |
|---|---|---|---|
| Jitsuyo Shinan Koho | 1922–1996 | Toroku Jitsuyo Shinan Koho | 1994–2003 |
| Kokai Jitsuyo Shinan Koho | 1971–2003 | Jitsuyo Shinan Toroku Koho | 1996–2003 |

Electronic data base consulted during the international search (name of data base and, where practicable, search terms used)

| C. DOCUMENTS CONSIDERED TO BE RELEVANT | | |
|---|---|---|
| Category* | Citation of document, with indication, where appropriate, of the relevant passages | Relevant to claim No. |
| X<br>Y | JP 2002-118306 A (Matsushita Electric Industrial Co., Ltd.),<br>19 April, 2002 (19.04.02),<br>Par. No. [0079]; Figs. 1, 2<br>& EP 1207564 A | 1,6<br>2-5,7,8,10,<br>11,13,14 |
| X<br>Y | JP 11-509956 A (MKE Quantum Components Colorado L.L.C.),<br>31 August, 1999 (31.08.99),<br>Fig. 3A<br>& US 5668688 A | 1,6<br>2-5,7,8,10,<br>11,13,14 |
| Y<br><br>X | JP 7-287817 A (Citizen Watch Co., Ltd.),<br>31 October, 1995 (31.10.95),<br>Full text; all drawings<br>(Family: none) | 2-5,7,8,10,<br>11,13,14<br>9,12 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 04 November, 2003 (04.11.03) | 18 November, 2003 (18.11.03) |

| Name and mailing address of the ISA/ | Authorized officer |
|---|---|
| Japanese Patent Office | |
| Facsimile No. | Telephone No. |

Form PCT/ISA/210 (second sheet) (July 1998)

## INTERNATIONAL SEARCH REPORT

International application No.

PCT/JP03/12834

| C (Continuation). DOCUMENTS CONSIDERED TO BE RELEVANT | | |
|---|---|---|
| Category* | Citation of document, with indication, where appropriate, of the relevant passages | Relevant to claim No. |
| P,X | JP 2003-229612 A (Toshiba Corp.), 15 August, 2003 (15.08.03), Full text; all drawings (Family: none) | 1,6 |

Form PCT/ISA/210 (continuation of second sheet) (July 1998)

**INTERNATIONAL SEARCH REPORT**

| International application No. |
| --- |
| PCT/JP03/12834 |

**Box I   Observations where certain claims were found unsearchable (Continuation of item 2 of first sheet)**

This international search report has not been established in respect of certain claims under Article 17(2)(a) for the following reasons:

1. ☐ Claims Nos.:

   because they relate to subject matter not required to be searched by this Authority, namely:

2. ☐ Claims Nos.:

   because they relate to parts of the international application that do not comply with the prescribed requirements to such an extent that no meaningful international search can be carried out, specifically:

3. ☐ Claims Nos.:

   because they are dependent claims and are not drafted in accordance with the second and third sentences of Rule 6.4(a).

**Box II   Observations where unity of invention is lacking (Continuation of item 3 of first sheet)**

This International Searching Authority found multiple inventions in this international application, as follows:

```
Claims 1-8 attempt to omit a conventional magnetic domain control film.
Claims 9-14 provide a shielding soft magnetic element in parallel with a
magnetoresistance effect film.
```

1. ☐ As all required additional search fees were timely paid by the applicant, this international search report covers all searchable claims.

2. ☒ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**     ☐     The additional search fees were accompanied by the applicant's protest.

☐     No protest accompanied the payment of additional search fees.

Form PCT/ISA/210 (continuation of first sheet (1)) (July 1998)